# EUROPEAN PATENT APPLICATION

(11) **EP 4 651 383 A1**
(43) Date of publication of application: **19.11.2025**
(21) Application number: 23916129.2
(22) Date of filing: 06.11.2023
(51) Int. Cl.: H03M 7/30

(54) **SIGNAL SENDING DEVICE, SIGNAL RECONSTRUCTION PROCESSING DEVICE, AND SIGNAL TRANSMISSION SYSTEM**

(30) Priority: 10.01.2023 JP 2023001730
(71) Applicant: The University of Osaka, Osaka 565-0871 (JP)
(72) Inventor: KANEMOTO, Daisuke, Suita-shi, Osaka 565-0871 (JP)
(74) Representative: DTS Patent- und Rechtsanwälte PartmbB
(86) International application number: PCT/JP2023/039793
(87) International publication number: WO 2024/150511

(57) **Abstract**

A sensing unit 10 includes a measurement part 12 that compresses a target signal based on an observation matrix Φ and captures a first signal, a communication part 15 that sends the first signal to an outside reconstruction processing unit 20, the first signal being captured into the measurement part 12, and a switching signal output part 16 that outputs a switching signal. The measurement part 12, when receiving the switching signal, compresses the target signal at lower compression than the first signal and captures a second signal, and a first communication part sends the captured second signal, in place of the first signal, to the outside reconstruction processing unit 20. This provides a signal transmission technology capable of low power consumption.

## Description

### Technical Field

The present invention relates to a signal transmission technology capable of low power consumption.

### Background Art

In recent years, with the spread of IoT (Internet of Things), the demand for sensing devices that, for example, sense the state of a living body or the like and wirelessly send a sensed biological signal to a computer (an edge computer) has been further increasing. In a case of devices that sense the biological signal, wearable types to be worn on the body are common, so that the miniaturization and long-term operability of the devices are desired. Accordingly, even a small battery needs to continue to operate for a long period of time, so that the development of low power consumption technology for the sensing devices is highly requested. Therefore, today, as disclosed in Non-Patent Literatures 1 to 4, the compressed sensing technology capable of significantly reducing power consumption by sensing while compressing an electroencephalogram signal is proposed, and mounting to a large number of sensing devices is being considered.

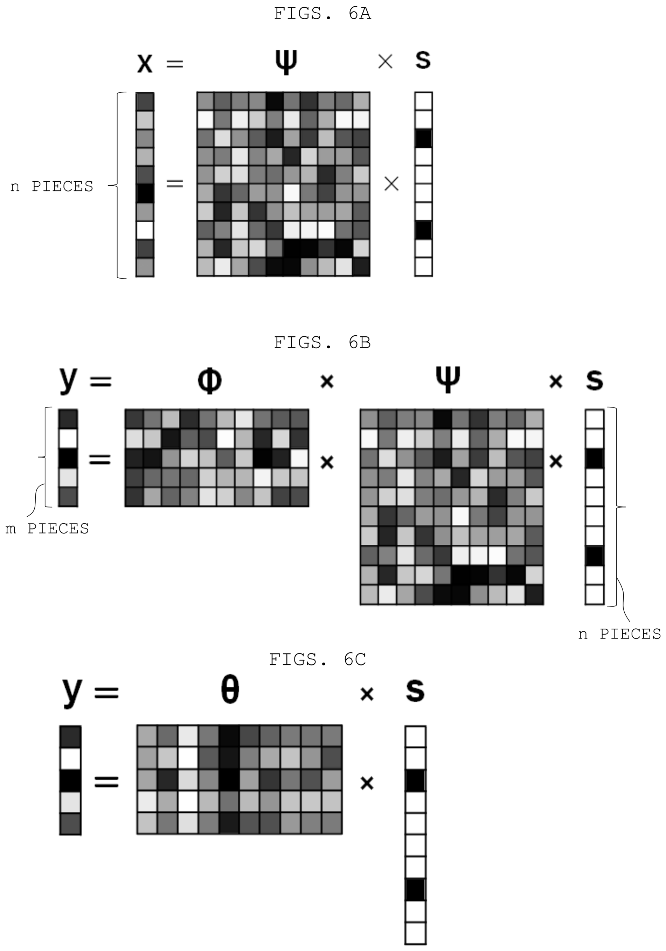

FIG. 6 is a diagram illustrating basic processing of compressed sensing, (A) is a diagram representing a signal vector x obtained by sensing as a certain dictionary matrix Ψ and a scattered (that is, including a large number of zero level elements or elements that may be regarded as zero level) sparse vector s, (B) is a diagram illustrating obtaining a signal vector x and a compressed signal y by use of an observation matrix Φ using signal compression, and (C) is a diagram showing, when sensing matrix θ = Φ × Ψ, a relationship between the compressed signal y of (B) and the sparse vector s using the sensing matrix θ. It is to be noted that, in FIG. 6, the scattered shading in each square determined by rows and columns represents a signal level for convenience, and, in particular, a white square represents the zero level. More specifically, in the compressed sensing, a signal vector x with n elements is multiplied by an m × n (m < n) observation matrix Φ to obtain the compressed signal y with m elements (see FIG. 6(B)). It is generally impossible to, under the condition of m < n, accurately reconstruct x from y and Φ. However, in a case in which x is able to be represented by the product of a certain dictionary matrix Ψ and the scattered sparse vector s (see FIG. 6(A)), various algorithms that estimate the sparse vector s from a compression vector y and the sensing matrix θ are present, and are able to obtain the reconstruction signal ^x by the product of the estimated estimation vector ^s and the dictionary matrix Ψ. As a reconstruction algorithm, for example, BSBL (Block Sparse Bayesian Learning) (Non-Patent Literature 5), OMP (Orthogonal Matching Pursuit), or the like, are well-known. It is important that whether or not reconstruction is possible by the compressed sensing depends on whether the sensed signal is able to be converted into a sparse vector. In other words, it is important that a dictionary matrix Ψ that is able to be converted into a vector having high sparsity is present. For example, a large number of signals in nature, such as biological signals, have a fixed signal pattern and have been found to have a tendency to be transformable into sparse vectors by use of a specific dictionary matrix.

While the compressed sensing is one of the important technologies for low power consumption, as a kind of irreversible compression as described above, maintenance and improvement of reconstruction accuracy are desired. However, the reconstruction accuracy and reconstruction time have a trade-off relationship, so that shortening of the time required for reconstruction is a problem to achieve highly accurate reconstruction. For example, the OMP reconstruction algorithm provides a very short reconstruction time but gives no expectation of the reconstruction accuracy, and, on the other hand, the BSBL reconstruction algorithm is a highly accurate reconstruction method that utilizes Bayesian estimation but has a computation time-consuming problem.

### Citation List

### Non-Patent Literature

Non-Patent Literature 1: Daisuke Kanemoto, Shun Katsumata, Masao Aihara, and Makoto Ohki, "Framework of Applying Independent Component Analysis After Compressed Sensing for Electroencephalogram Signals," in Proc. IEEE Biomed. Circuits Syst. Conf. (BioCAS), Oct. 2018, pp. 145-148.
Non-Patent Literature 2: Daisuke Kanemoto, Shun Katsumata, Masao Aihara, and Makoto Ohki, "Compressed Sensing Framework Applying Independent Component Analysis after Undersampling for Reconstructing Electroencephalogram Signals," IEICE Trans. Fundamentals, vol. E103-A, no. 12, pp. 1647-1654, Dec. 2020.
Non-Patent Literature 3: Yuki Okabe, Daisuke Kanemoto, Osamu Maida, and Tetsuya Hirose, "Compressed Sensing, EEG Measurement Technique with Normally Distributed Sampling Series," IEICE Trans. Fundamentals, vol. E105-A, no.10, pp. 1429-1433, Oct. 2022.
Non-Patent Literature 4: Shun Katsumata, Daisuke Kanemoto, and Makoto Ohki, "Applying Outlier Detection and Independent Component Analysis for Compressed Sensing EEG Measurement Framework," in Proc. IEEE Biomed. Circuits Syst. Conf. (BioCAS), Oct. 2019, pp. 1-4.
Non-Patent Literature 5: Z. Zhang, T.P. Jung, S. Makeig, and B.D. Rao, "Compressed sensing of EEG for wireless telemonitoring with low energy consumption and inexpensive hardware," IEEE Trans. Biomed. Eng., vol. 60, no.1, pp. 221-224, Jan. 2013.

### Summary of Invention

### Technical Problem

The present inventor has proposed a method that, by utilizing previously obtained signals as a dictionary based on the background described above, enables high-accuracy and high-speed reconstruction even when BSBL is utilized as the reconstruction algorithm (patent application No. 2022-28896, application filing date February 28, 2022).

Incidentally, in a case in which this method is applied to small quantity and large variety such as IoT or a user-dependent biological signal, as a target, in order to achieve a sensing apparatus that performs compression and reconstruction processing suitable for various detection signals, it is desirable to include an optimal dictionary corresponding to the various detection signals. In addition, even when an object to be measured, that is, the detection signal itself, temporally varies, for example, or changes or shifts slightly, it is necessary to maintain suitable sensing without degrading the reconstruction accuracy both for such variations, changes and shifts (hereinafter referred to as variations) and also for the user dependence. Moreover, further improvement is requested in terms of the low power consumption technology in compressed sensing processing and in sending of captured signals to a reconstruction side.

The present invention, in view of the foregoing, is directed to provide a signal sending apparatus, a signal reconstruction processing apparatus, and a signal transmission system that enable low power consumption in compressed sensing processing and external sending.

### Solution to Problem

A signal sending apparatus according to the present invention includes a measurement part that compresses a target signal based on an observation matrix and captures a first signal, a first communication part that sends the first signal to outside, the first signal being captured into the measurement part, and a switching signal output part that outputs a switching signal, and the measurement part, when receiving the switching signal, compresses the target signal at lower compression than the first signal and captures a second signal, and the first communication part sends the captured second signal, to the outside.

According to the present invention, the target signal is compressed by the measurement part through the observation matrix, is captured as a first signal, and is sent to the outside by the first communication part. In addition, the measurement part is made to compress the target signal at lower compression than the first signal and capture a second signal, and, when receiving the switching signal from the switching signal output part, the second signal is sent to the outside by the first communication part. Accordingly, the measurement part and the first communication part perform the compression to the first signal and the external sending of the compressed signal as normal operations, which enables an operation with low power consumption. In addition, at a timing relevant to, for example, the update of the dictionary matrix for reconstruction, or the like, in a case in which an available second signal is captured, although power consumption is temporarily increased by low compression processing and sending processing, low-power operation is possible in other normal times, so that, while the operation is performed with low power consumption as a whole, the maintenance or the like of the reconstruction accuracy of the detection signal, for example, is able to be achieved. It is to be noted that lower compression than the first signal includes no compression.

In addition, a signal reconstruction apparatus according to the present invention includes a second communication part that receives signals from the first communication part of the signal sending apparatus, a dictionary memory that records a dictionary matrix, a reconstruction algorithm part that obtains an estimation signal by use of the observation matrix and the dictionary matrix, from the first signal among the signals received by the second communication part, and obtains a product of the obtained estimation signal and the dictionary matrix and derives a reconstruction signal, and a dictionary generation part that generates a new dictionary matrix, from the second signal among the signals received by the second communication part, and stores in the dictionary memory.

According to the present invention, the estimation signal is obtained from the first signal by use of the observation matrix and the dictionary matrix by the reconstruction algorithm part, and the product of the obtained estimation signal and the dictionary matrix is obtained to derive the reconstruction signal. On the other hand, a new dictionary matrix is generated from the second signal by the dictionary generation part and is stored in the dictionary memory. In this manner, the dictionary matrix is generated and updated from the second signal to maintain high reconstruction accuracy for the reconstruction signal.

In addition, a signal transmission system according to the present invention includes the signal sending apparatus and the signal reconstruction processing apparatus that are connected by the communication part, and this configuration enables low power consumption and maintains the high reconstruction accuracy. Advantageous Effects of Invention

According to the present invention, a signal sending apparatus and a signal transmission system capable of low power consumption are able to be provided. In addition, regardless of the temporal variations or the like of a target, a signal reconstruction processing apparatus capable of maintaining the reconstruction accuracy of a detection signal is able to be provided.

### Brief Description of Drawings

[FIG. 1] is a block diagram showing a first embodiment of a compressed sensing system.
[FIG. 2] is a block diagram showing functionally a partial configuration of the compressed sensing system of FIG. 1, (A) is a diagram of a side of a sensing unit, and (B) is a diagram of a side of a reconstruction processing unit.
[FIG. 3] is a flowchart showing an example of a procedure of dictionary update processing to be executed by a control part of the reconstruction processing unit.

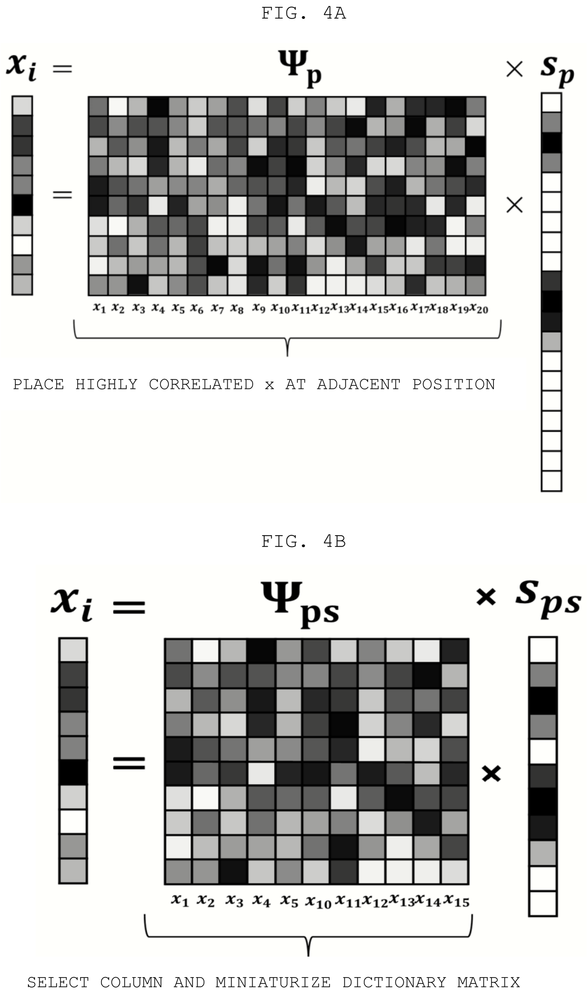

[FIG. 4] is a diagram briefly illustrating a relationship between a discretized detection signal xi and a dictionary matrix Ψ, more specifically, shows a configuration example of the dictionary matrix Ψ with the set number of columns formed from the discretized detection signal xi, and (A) is a diagram of a dictionary made of 20 columns (the set number of columns) when sorted, and (B) is a diagram of a smaller size dictionary made of 11 columns (the set number of columns) selected from the 20 columns of discretized detection signals xi in (A), in consideration of an appearance rate or the like.
[FIG. 5] is a block diagram showing a second embodiment of the sensing unit.
[FIG. 6] is a diagram illustrating basic processing of compressed sensing, (A) is a diagram representing a signal vector x obtained by sensing as a certain dictionary matrix Ψ and a distant (that is, including a large number of zero level elements or elements that may be regarded as zero level) sparse vector s, (B) is a diagram illustrating obtaining a signal vector x and a compressed signal y by use of an observation matrix Φ using signal compression, and (C) is a diagram showing, when sensing matrix θ = Φ × Ψ, a relationship between the compressed signal y of (B) and the sparse vector s using the sensing matrix θ.
[FIG. 7] is a diagram illustrating a relationship between a compressed sensing method and information to be sent from a reconstruction processing unit toward the sensing unit with the update of the dictionary matrix, (A) is a diagram showing the compressed sensing method that utilizes random undersampling, (B) is a diagram showing an analog domain compressed sensing method, and (C) is a diagram showing a digital domain compressed sampling method.

### Description of Embodiments

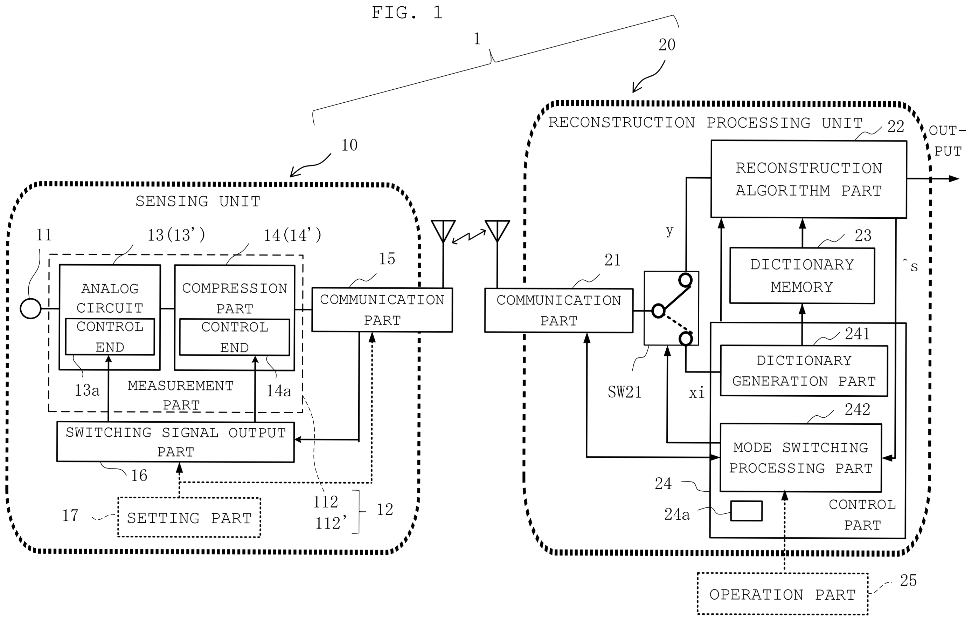

FIG. 1 is a block diagram showing a first embodiment of a compressed sensing system 1 to be applied as a signal sending apparatus according to the present invention. The compressed sensing system 1 includes a sensing unit 10 that is attached to a living body and measures a state of an object to be measured in a wearable aspect, for example, and a reconstruction processing unit 20 that mounts a processor (a CPU or the like). First, the outline of the sensing unit 10 and the reconstruction processing unit 20 will be described.

The sensing unit 10 includes a sensor 11, a measurement part 12 having an analog circuit 13 including an amplifier and a filter for preprocessing and a compression part 14 made of an ADC (Analog Digital Convertor), for example, and a communication part 15 including an antenna capable of near field communication such as Bluetooth (registered trademark) (Bluetooth) or Wi-Fi, for example, with the reconstruction processing unit 20. In addition, the sensing unit 10 includes a switching signal output part 16 that outputs a switching signal that causes the measurement part 12 to switch modes to be described below, and a setting part 17 for mode switching to be used as needed. It is to be noted that, although not illustrated, the sensing unit 10 interiorly houses a battery such as a secondary battery or a power source such as a power generation element. The sensing unit 10 makes it possible to perform remote sensing with respect to the reconstruction processing unit 20 by interiorly housing a battery, a power generation element, or the like. It is to be noted that the sensor 11 may be functionally included in the measurement part 12.

The reconstruction processing unit 20 includes a communication part 21 including an antenna that sends and receives a signal to and from the communication parts 15, a reconstruction algorithm part 22 that generates a reconstruction signal from a compressed signal received through the communication part 21, and a dictionary memory 23 that stores various kinds of information applied to reconstruction processing, such as a dictionary matrix Ψ and sensing matrix θ (= Φ × Ψ), for example. It is to be noted that an observation matrix Φ is a transformation matrix applied in compressed sensing. In addition, the reconstruction processing unit 20 includes a control part 24 that executes the update processing of the dictionary matrix Ψ, and an operation part 25 that directs the mode switching by a manual operation from the outside, used as needed. The control part 24 has a processor (a CPU or the like), and a memory part 24a that stores a control program to selectively switch and execute a compressed sensing mode and a dictionary generation mode. The control part 24 executes the control program to function as a dictionary generation part 241 and a mode switching processing part 242 that will be described below.

Referring back to the sensing unit 10, the sensor 11 is able to be employed to correspond to various detection targets, and, in the present embodiment, has an electrode that measures a biological signal, for example, an electroencephalogram signal (an electrical signal). The sensor 11 may be placed so that a pair of human body attached-type electrodes, for example, or, a predetermined pair of electrodes that are pre-dispersedly mounted on a headgear worn on a head, for example, may be in contact with a scalp.

The analog circuit 13 and the compression part 14 of the measurement part 12, in the present embodiment, when the switching signal from the switching signal output part 16 is inputted into control ends 13a and 14a for operation switching, are switched between the compressed sensing mode and the dictionary generation mode to be described below and operate. It is to be noted that the measurement part 12 of which the circuit state when operating in the compressed sensing mode is referred to as a first circuit 112 for convenience, includes the analog circuit 13 and the compression part 14, and, on the other hand, of which the circuit state when operating in the dictionary generation mode is referred to as a second circuit 112' for convenience, includes an analog circuit 13' and a compression part 14'.

The switching signal output part 16, when receiving a signal of switching instructions from a side of the reconstruction processing unit 20 to be described below or the setting part 17, outputs a switching signal to switch the mode to the dictionary generation mode. It is to be noted that the setting part 17 includes a timer, for example, and, when timing an elapsed time from the start of the operation of the sensing unit 10 or a predetermined repetition time, outputs the switching instructions to the switching signal output part 16 and also outputs to the mode switching processing part 242 through the communication part 15. This, even when the signal of switching instructions is emitted on the side of the sensing unit 10, is able to link the sensing unit 10 and the reconstruction processing unit 20 and execute the dictionary generation mode.

Herein, the compressed sensing mode is a mode of a normal operation of the sensing unit 10 in a state in which power consumption is significantly reduced. In the compressed sensing mode, in the first embodiment, although an S/N ratio is reduced by circuit noise generated from the analog circuit 13 to be driven with low power consumption, data is compressed and obtained with low sampling in the compression part 14 and the amount of data to be sent toward the reconstruction processing unit 20 is reduced through compression, and thus power consumption is significantly reduced in the preprocessing, the compression processing, and the sending processing. It is to be noted that the analog circuit 13, depending on the application or the like, may employ a circuit of a high S/N ratio even in the compressed sensing mode.

Next, a dictionary matrix Ψ that gives sparsity to a detection signal x will be described. As a case in which the detection signal x is able to be represented by a sparse vector s with high sparsity by the dictionary matrix Ψ, a case in which each column vector configuring the dictionary matrix Ψ is highly correlated with the detection signal x may be considered. For example, a signal of which the waveform that has relatively similar characteristics continues, such as a biological signal, is able to be regarded as a signal having constant correlation between extracted vectors since the signal characteristics do not significantly change from time to time. On the other hand, when a biological signal temporally varies, the correlation with the dictionary matrix Ψ is gradually reduced, which deteriorates sparsity, and, as a result, the accuracy (the reconstruction accuracy) of the reconstruction signal ^x is reduced. Then, the mode is switched to the dictionary generation mode at an appropriate timing, and the latest biological signal is obtained as a high quality signal to be used in a dictionary to update the dictionary matrix Ψ, which is designed to maintain the accuracy of the reconstruction signal ^x. The dictionary generation mode is a mode in which biological signals for the predetermined number of columns are temporarily obtained with high sampling at an appropriate timing. More specifically, the dictionary generation mode, in the first embodiment, significantly reduces the occurrence of the circuit noise by operating the analog circuit 13' with high power consumption and increases the S/N ratio or extends a signal bandwidth. In addition, typically a high-sampling operation is performed without compression and, while the power consumption is increased for the sending of more data toward the reconstruction processing unit 20, data to be used for the dictionary is obtained with high accuracy.

Several methods of changing the S/N ratio of the analog circuit 13 include, for example, a method of adjusting the current flowing into a circuit. More specifically, the switching between the compressed sensing mode and the dictionary generation mode in the sensing unit 10 according to the first embodiment is performed by the switching signal from the switching signal output part 16. In the first embodiment, the circuit configuration of the analog circuit 13 that has an amplifier and a filter is mostly used for a double purpose, and the mode of operation is switched by the switching signal to be inputted to the control end 13a, which significantly reduces the size of the circuit configuration.

Various methods of adjusting the current flowing into the amplifier in the analog circuit 13 are able to employ, for example, an aspect in which a non-illustrated control circuit is employed to control a current value flowing into the amplifier, or an aspect in which the current value is adjusted by a binary switching signal according to a mode that is outputted from the switching signal output part 16 to the control end 13a is adjusted in magnitude. The amplifier in the analog circuit 13 executes the compressed sensing mode with high noise but low power consumption (first power), and the amplifier in the analog circuit 13' executes the dictionary generation mode with high power consumption (second power) but low noise.

In addition, the filter in the analog circuit 13, similar to the amplifier, is also made to have a higher S/N ratio in the dictionary generation mode, depending on the magnitude of the power consumption according to the mode. Furthermore, in a case of a filter, by use of the binary switching signal according to the mode, for example, an aspect in which transconductance or the like in a filter circuit is controlled by voltage or an aspect in which a functional part of L and C elements configuring the filter is switched is able to be considered. In this manner, the S/N ratio is adjusted, and a bandpass band of the filter is adjusted, and, for example, while a first passband is set in the compressed sensing mode, in a second passband wider than the first passband in a dictionary creation mode, a signal with wider frequency components is obtained, which enables the generation of a highly accurate dictionary. It is to be noted that mode switching for the amplifier and the filter of the analog circuit 13 may be applied not only to both but to at least one.

Since the dictionary generation mode, even when different in update frequency depending on a target, is a short time with respect to the entire operating period in the compressed sensing mode, the intermittent adoption of the dictionary generation mode does not cause an increase in power consumption as a whole. In addition, the dictionary matrix Ψ is generated by a low-noise and highly accurate signal in the dictionary generation mode, the reconstruction processing of the detection signal x is performed by use of this dictionary matrix Ψ, so that, even when noise is mixed in the detection signal x, the noise is less likely to be reconstructed, and thus a noise reduction effect in the compressed sensing mode is able to be achieved.

Next, the compression part 14 selectively executes the dictionary generation mode in which target signals outputted from the analog circuit 13 are high-sampled for 3 seconds as one frame with a predetermined frequency, for example, 200 Hz, equivalent to the Nyquist sampling rate in a case of an electroencephalogram signal, for example, and the compressed sensing mode of the compression processing in which target signals are low-sampled while thinning to a predetermined ratio, for example, 1/10.

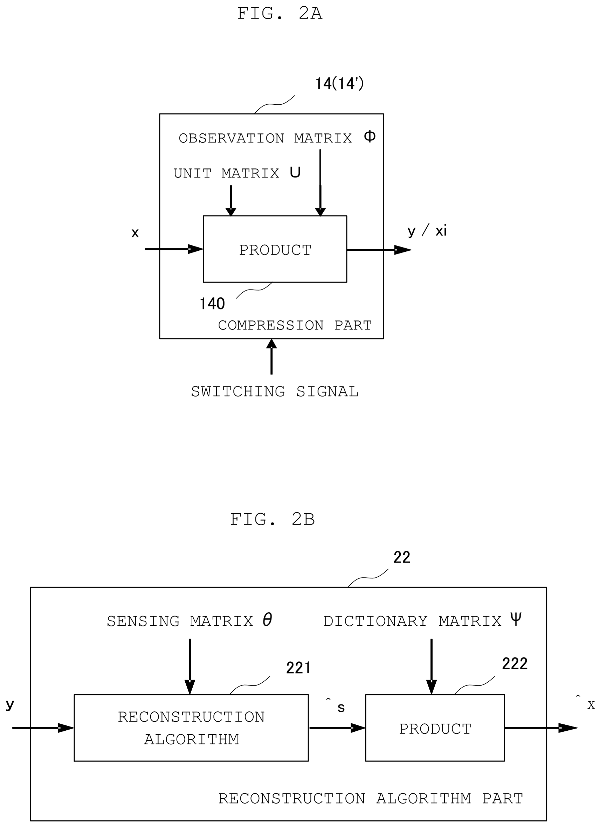

The details of the compression part 14, as shown in FIG. 2(A), have a calculation module 140 that performs a product operation, and, in the compressed sensing mode, a calculation that takes the product of the sampled detection signal x and the observation matrix Φ used for compression is performed to achieve the compressed signal y as y = Φx. It is to be noted that the compressed sensing may include an aspect in which the ADC or the like configuring the compression part 14 performs a sampling operation while thinning at a preset timing, based on the observation matrix Φ.

In the dictionary generation mode, the compression part 14', by a switching signal, applies a unit matrix U (a square matrix of which the diagonal components are 1 and the others are zero), for example, instead of the observation matrix Φ, and outputs the discretized detection signal xi (see FIG. 2(A)) discretized with uncompressed high sampling as a signal for updating the dictionary. It is to be noted that the high sampling in the dictionary generation mode is not limited to the uncompressed sensing described above but may also be compressed sampling at a compression ratio lower than the compressed sensing mode.

It is to be noted that the calculation module 140 is not limited to a configuration of hardware such as ADC but may also be configured by software using a compression algorithm. In addition, in the compressed sensing mode, information is compressed by using a matrix that achieves random undersampling, a Bernouilli matrix, or a matrix configured by Gaussian random elements as the observation matrix Φ. The communication part 15 sends the compressed signal y toward the reconstruction processing unit 20 every time the compressed signal y is obtained, for example, for each one frame (3 seconds).

It is to be noted that a sampling operation for each frame may be continuous or may be started using a specific signal within the electroencephalogram signal as a trigger. In addition, a frame length is preferably set to include a time width that includes periodic tendency within the electroencephalogram signal.

Next, the reconstruction processing unit 20 will be more specifically described. The communication part 21 receives a signal from the sensing unit 10 and also sends a signal of switching instructions from the reconstruction processing unit 20 to the switching signal output part 16. The switch SW21, in the compressed sensing mode, leads the received compressed signal y to the reconstruction algorithm part 22, and, on the other hand, leads the received discretized detection signal xi to the dictionary generation part 241 as a signal for updating the dictionary in the dictionary generation mode.

Next, the reconstruction processing in the compressed sensing mode will be described. The reconstruction algorithm part 22, as shown in FIG. 2(B), has a reconstruction algorithm execution module 221 and a calculation module 222 that performs the product operation. In the reconstruction algorithm part 22, when the compressed signal y of a frame to be processed is inputted, the compressed signal y and the sensing matrix θ (= Φ × Ψ) are inputted to the reconstruction algorithm execution module 221 in which the BSBL algorithm is employed, for example, to calculate the estimation vector ^s having sparsity. It is to be noted that, in a case in which the detection signal x is able to be represented by a product of a certain dictionary matrix Ψ and a distant (that is, containing a large number of zero level elements or elements that may be regarded as zero level) sparse vector s, various algorithms that estimate the sparse vector s from the compressed signal y and the sensing matrix θ are present. As a reconstruction algorithm, for example, BSBL (Block Sparse Bayesian Learning), OMP (Orthogonal Matching Pursuit), or the like, is well-known.

Subsequently, in the calculation module 222, the calculated estimation vector ^s and the dictionary matrix Ψ are inputted, and the reconstruction signal ^x corresponding to the detection signal x is derived and is outputted to the outside or a non-illustrated image display device. It is to be noted that the derived reconstruction signal ^x is sent to a non-illustrated analysis part as needed, or is stored in the dictionary memory 23 or a non-illustrated different memory. In addition, in a case in which the detection target is the electroencephalogram signal, for example, the analysis is assumed to have applications not only in the healthcare and medical fields including diagnosis of dementia, epilepsy, sleep disorders, Alzheimer's disease, and other brain diseases, measurement of concentration, determination of pleasure or displeasure, or the like but in a wide range of fields.

Next, in the control part 24, the dictionary generation part 241 executes a function to generate a new dictionary matrix Ψ. The mode switching processing part 242 outputs switching instructions to switch the mode to the dictionary generation mode, and, in the present embodiment, the switching instructions are issued in a case in which a predetermined condition is determined to be cleared, or may include a case in which issuance is made without a condition as needed. The signal of switching instructions outputted from the mode switching processing part 242 is led to the switching signal output part 16 through the communication parts 21 and 15. This, when the signal of switching instructions is emitted from the side of the reconstruction processing unit 20, is able to link the sensing unit 10 and the reconstruction processing unit 20 and execute the dictionary generation mode.

Herein, the predetermined condition for generating a switching signal refers to a case in which the reconstruction accuracy of the reconstruction signal ^x is preferably reduced and the dictionary matrix Ψ needs to be updated. The determination of whether the accuracy of the reconstruction signal ^x is reduced is able to be made by various methods. For example, the deterioration of the sparsity of the estimation vector ^s, the deterioration (distribution) of the histogram of the spectrum of the reconstruction signal ^x, and the reduction in the correlation between the reconstruction signal ^x and the dictionary matrix Ψ, are able to make the determination. In addition, these determinations may include a method that uses a comparison of the current value to a threshold value, as well as a method that uses a difference in magnitude between two values in a temporal direction. In the present embodiment, the mode switching processing part 242 sequentially captures the estimation vector ^s outputted from the reconstruction algorithm execution module 221 for each reconstruction and calculates a value showing the sparsity, and, when the difference between the previous value and the current value, that is, the amount of deterioration exceeds a threshold value, outputs the switching instructions to the dictionary generation part 241 and the switching signal output part 16.

It is to be noted that, in the following cases, a case of no condition on the output of the switching instructions may be included. In other words, when, by use of a non-illustrated timer in the control part 24, a predetermined elapsed time of a start of a sensing operation to a predetermined observation target is clocked, or an external operation from the operation part 25 is received, the switching instructions are outputted from the mode switching processing part 242.

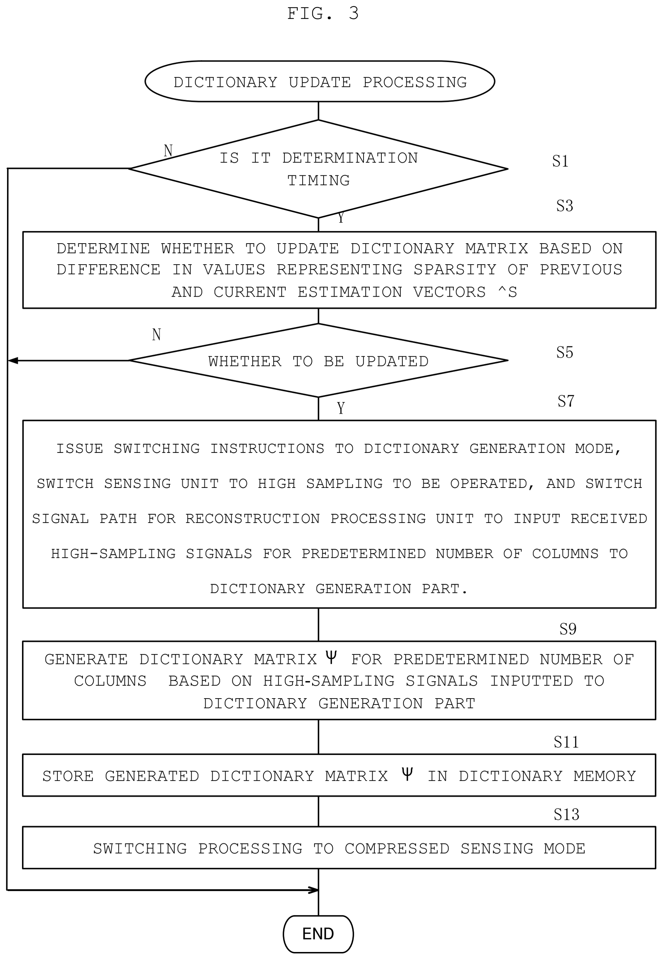

FIG. 3 is a flowchart showing an example of a procedure of dictionary update processing to be executed by the control part 24. When a predetermined timing during reconstruction processing at each time is monitored as a determination timing and corresponds to the determination timing (Yes in step S1), the mode switching processing part 242 determines whether or not the dictionary matrix is updated based on the magnitude between the difference between the previous value and the current value showing the sparsity of the estimation vector ^s and the threshold value, for example (Step S3). In other words, in a case in which the difference showing deterioration exceeds the threshold value, the dictionary matrix Ψ is determined to be updated (Yes in Step S5), and, on the other hand, in a case in which the difference showing deterioration does not exceed the threshold value, this flow is exited as no update is required (No in Step S5). The mode switching processing part 242, in a case of determining that the dictionary matrix Ψ is updated in Step S5, outputs the switching instructions to the dictionary generation mode, switches and operates the sensing unit 10 to a high sampling state, captures the discretized detection signals xi (see FIG. 2(A)) for the predetermined number of columns (a plurality of frames), and switches a signal path with respect to the reconstruction processing unit 20 so that the received discretized detection signals xi may be inputted into the dictionary generation part 241 (Step S7).

Subsequently, the dictionary generation part 241 generates the dictionary matrix Ψ for the predetermined number of columns based on the inputted discretized detection signal xi for a plurality of frames (Step S9) and transfers the generated dictionary matrix Ψ to the dictionary memory 23 to be updated and stored (Step S11). Then, the mode switching processing part 242 executes switching processing to return the mode to the compressed sensing mode (Step S13). It is to be noted that, in a case in which the determination of whether or not update is required is not required, for example, in a case in which the timer clocks a predetermined time, processing may be performed to immediately proceed to Step S7.

It is to be noted that, in Step S7, in the dictionary generation mode, the dictionary generation part 241 continues to capture the discretized detection signal xi of one frame for the predetermined number of columns, with high sampling. Then, in Step S9, the dictionary generation part 241, based on a dictionary generation program, forms a matrix by aligning the amount of one frame as a column vector in a captured order, or, for the purpose of higher correlation, forms a new matrix by performing predetermined reordering (sorting) in a column direction, or forms a matrix by performing selective thinning in consideration of the appearance rate or the like. It is to be noted that the number of columns of the dictionary matrix Ψ is equal to the number of lines of the sparse vector s. Accordingly, in the aspect of selective thinning in consideration of the appearance rate or the like, among the above, the large number of frames of the discretized detection signal xi may be obtained in advance, including the number of columns to be thinned. In this case, although the number of frames of the discretized detection signal xi may be an aspect in which the number of preset columns is obtained with a predetermined time or may be an aspect (that is, the predetermined number of columns in which the number of obtained frames can vary) in which time to obtain may be set to a predetermined time capable of being properly adjusted. For example, the mode switching processing part 242 may correspond to the degree of reduction in the reconstruction accuracy of the reconstruction signal ^x, as described above, may determine the degree of the deterioration of the sparsity of the estimation vector ^s, the deterioration (distribution) of the histogram of the spectrum of the reconstruction signal ^x, and the reduction in the correlation between the reconstruction signal ^x and the dictionary matrix Ψ, and may adjust the time to obtain, that is, the number of obtained columns, corresponding to the determined degree of the deterioration.

FIG. 4 is a diagram briefly illustrating a relationship between the discretized detection signal xi and the dictionary matrix Ψ, more specifically, shows a configuration example of the dictionary matrix Ψ with the set number of columns formed from the discretized detection signal xi, and (A) is a diagram of a dictionary made of 20 columns (the set number of columns) when sorted, and (B) is a diagram of a smaller size dictionary made of 11 columns (the set number of columns) selected from the 20 columns of discretized detection signals xi in (A), in consideration of the appearance rate or the like.

These are executed at the dictionary generation part 241 based on the dictionary generation program. The dictionary matrix Ψp shown in FIG. 4(A), in a case in which signals with similar detection targets are obtained, generates and arranges the discretized detection signal xi of one frame as a column vector. For example, herein, 20 column vectors x1 to x20 configure the dictionary matrix Ψp. Although the 20 column vectors may be arranged in the same order as obtained in the dictionary generation mode, herein, for example, the average frequency of the column vector is calculated (MATLAB (registered trademark) function meanfreq, for example), and the average frequency is sorted and rearranged in a height direction. In this manner, the average frequency is rearranged in order of height, that is, the highly correlated signals are placed in adjacent columns, so that the dictionary matrix Ψp that enables conversion to a sparse vector sp with higher sparsity (clearly sparse and dense) is created.

In addition, the appearance rate of the average frequency of the column vector is obtained as a histogram, the column vector with the average frequency having a high appearance rate shown in FIG. 4(B) is selectively employed, that is, highly correlated signals are selected, which thus also enables conversion to a sparse vector sps with high sparsity while being a smaller dictionary Ψps. In such a case, signals of the average frequency having the high appearance rate may be arranged. Alternatively, a selection of a frame having the high occurrence rate from a larger number of frames by sort processing makes it possible to create a dictionary with a higher correlation.

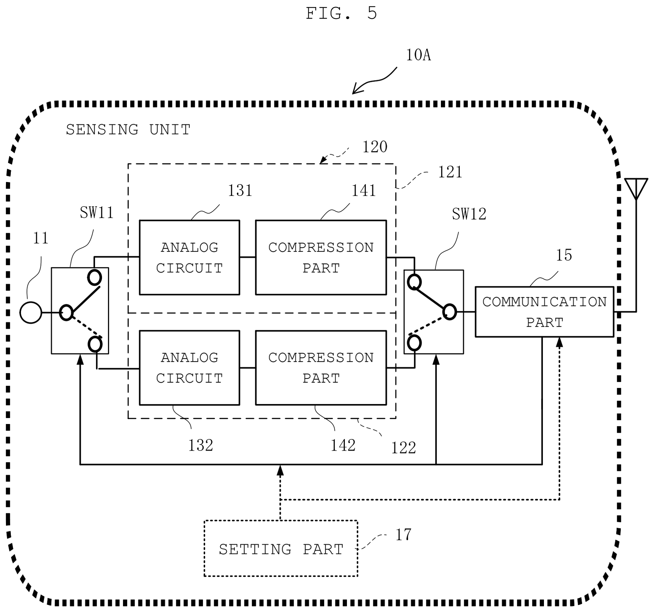

Subsequently, a second embodiment of the sensing unit 10 will be described by use of FIG. 5. The sensing unit 10 shown in FIG. 1 electrically controls an operation in each mode based on a switching signal. In contrast, in the measurement part 120 shown in FIG. 5, the switches SW11 and SW12 are configured to be switched according to the signal of switching instructions, and the first circuit 121 for the compressed sensing mode and the second circuit 122 for the dictionary generation mode that are provided in parallel are configured to be operated selectively. According to this configuration, the analog circuit 131 and the compression part 141 as well as the analog circuit 132 and the compression part 142 are configured by a circuit element corresponding to each mode and are designed with suppled power (the first and second electric power) or a bandpass band (the first, second passbands), so that the same operation as the operation of the measurement part 12 of FIG. 1 is able to be achieved, and, even when the sampling ratios of the two modes change significantly, the characteristics of each circuit are able to be individually designed for each mode.

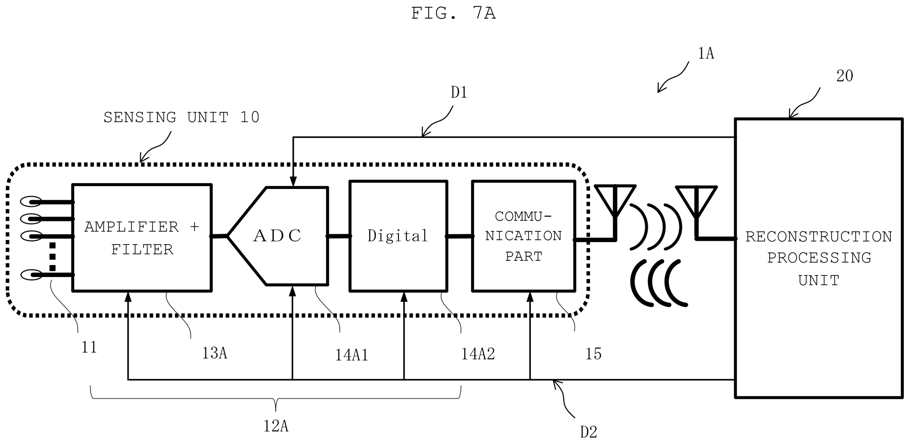

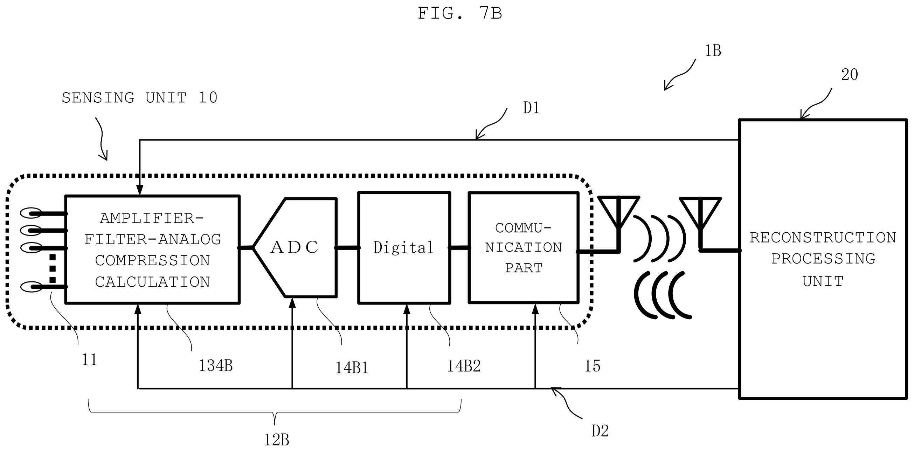

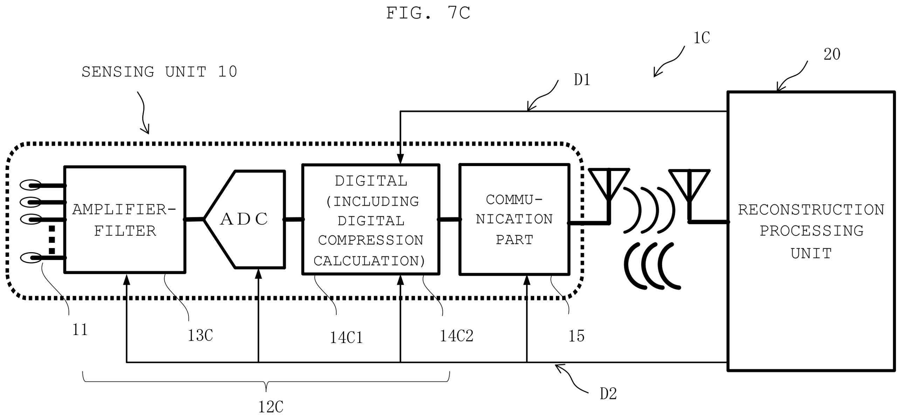

It is to be noted that the present invention is able to include the following aspects.
(1) The signal to be used to update the dictionary matrix is not limited to a signal from the same target but may be a signal from targets with the same characteristics.
(2) Although the embodiment describes an example in which the biological signal is described as a target, other signals with sparsity such as weather and environmental information (including a case in which a signal is transformed using the dictionary matrix, resulting that the signal has sparsity), and a current value and a voltage value, and other characteristics of physical quantity obtained by an IoT sensor or an IoT device, in a factory, for example, especially a smart factory, for monitoring an operational status in various facilities or the like, may be included.
(3) Although the embodiment describes an example in which the filter using a bandpass band as a passband is used as a filter provided in analog circuits 13, 13', 131, 132, the present invention is not limited to such a bandpass filter and are able to employ various kinds of filters with a designed passband, such as a high-pass filter, a low-pass filter, a notch filter.
(4) Although, in the embodiment, the compressed signal obtained in the compressed sensing mode and the signal obtained while compressed with a low compression ratio are selectively sent to the reconstruction processing unit 20, both sensing signals may also be obtained simultaneously and sent to the reconstruction processing unit 20. As a method of the same sending, any of time-division or frequency-division methods that are known at the time is able to be employed. It is to be noted that, regardless of whether or not simultaneous sending is performed, when signals in both directions are sent from the sensing unit 10 and the reconstruction processing unit 20, identification information such as a flag showing the type of signal may be added to a header of a sent signal column and sent. In addition, the communication parts 15 and 21 may individually include a configuration in which both sensing signals are sent and received.
(5) Although the embodiment describes an example in which the signal obtained with low compression sampling is applied for updating of the dictionary matrix, the present invention is not limited to the updating of the dictionary matrix and can be applied to other applications. For example, both the compressed signal obtained in the compressed sensing mode and the low compression or uncompressed signal obtained simultaneously are sent to the reconstruction side, and, on the reconstruction side, the signal reconstructed from the compressed signal obtained in the compressed sensing mode and the low compression or uncompressed signal are compared, which makes it possible to evaluate the signal quality obtained in the compressed sensing mode implemented currently. As an evaluation method, a method to use, for example, a difference in waveforms between the reconstructed signal and the signal obtained by the uncompressed sensing may be considered. Furthermore, an evaluation result is able be used to evaluate whether or not the currently created dictionary is able to be fully utilized in the compressed sensing mode, the degree of setting of the characteristics of a circuit on a sensing side, and the degree of setting of high and low compression ratios.
(6) In addition, the present invention provides the sensing unit to be used for small quantity and large variety such as IoT with a function of the dictionary generation mode, which makes it possible to generate the dictionary matrix corresponding to the signal from various targets and provide a sensing unit or a system with high versatility.
(7) Although the embodiment employs a method of reducing and compressing information while thinning by the ADC, as the compression parts 14, 14', 141, 142 that perform the compressed sensing, the present invention is not limited to such a compressed sensing method. For example, in addition to a method of compressing with a random undersampling rate, a compressed sensing method of compressing with a low sampling rate before AD conversion or after AD conversion is able to be employed (see FIG. 7).

FIG. 7 is a circuit configuration diagram illustrating a relationship between a compressed sensing method applicable to the present invention and information to be sent from the reconstruction processing unit 20 toward the sensing unit 10 with the update of the dictionary matrix Ψ, (A) shows the compressed sensing method that utilizes random undersampling, (B) shows an analog domain compressed sensing method, and (C) shows compressed sensing systems 1A, 1B, 1C of a digital domain compressed sensing method. The information to be sent from the reconstruction processing unit 20 to the sensing unit 10 includes information accompanied with improvement of the S/N ratio, instructions to change the passband of the circuit, and the update of the dictionary matrix Ψ in addition to a trigger for mode switching. For example, the dictionary matrix Ψ and the observation matrix Φ are related to each other, and the sensing matrix θ being the product of both has a significant impact on signal reconstruction accuracy. In other words, at a time when the dictionary matrix Ψ is created, the observation matrix Φ that improves the reconstruction accuracy is able to be solved on the side of the reconstruction processing unit 20, so that the more suitable observation matrix Φ is conveyed to the side of the sensing unit 10.

In FIG. 7(A), an amplifier-filter part 13A included in the measurement part 12A executes the same preprocessing as FIG. 1, and the ADC 14A1 executes the compression sampling. Then, the dictionary generation part 241, when updating the dictionary matrix Ψ, creates the observation matrix Φ corresponding to the contents of updating, and sends the created observation matrix Φ to the ADC 14A1 as sending information D1 so as to be updated and written. Therefore, when some noise may be mixed in with the sensed signal or the signal bandwidth is further narrowed down, reconstruction is possible with high accuracy. In other words, even when circuit characteristics are deteriorated or the power consumption is reduced, reconstruction signal quality is able to be assured. The reconstruction processing unit 20 sends and sets adjustment information of how much the circuit characteristics are able to be deteriorated to a circuit part corresponding to the sensing unit 10 as sending information D2. In addition, when the amount of information to be used for processing and transmission is reduced but the accuracy is able to be assured, in the same manner as described above, in a Digital 14A2 and the communication part 15, instructions to reduce the amount of information to be handled are sent from the reconstruction processing unit 20 to a circuit part corresponding to the side of the sensing unit 10 as the sending information D2. In this manner, by the reduction in the amount of information to be handled, further lower power consumption is able to be expected.

In FIG. 7(B), an amplifier-filter-analog compression calculation part 134B included in the measurement part 12B executes the same preprocessing as FIG. 1 and the compression sampling. More specifically, the amplifier-filter-analog compression calculation part 134B executes compression calculation on the preprocessed analog signal. It is to be noted that the forms of observation matrix Φ to be achieved in the analog domain have variety, and, for example, a Gaussian random matrix, Bernoulli, or the like can be applied. The reconstruction processing unit 20, at a time of updating the dictionary matrix Ψ, creates the observation matrix Φ that increases the reconstruction accuracy, and sends to the amplifier-filter-analog compression calculation part 134B as the sending information D1 so as to be updated and written. The observation matrix Φ is conveyed to the compression part on the side of the sensing unit 10, which enables suitable compression. It is to be noted that, in FIG. 7(B), the ADC 14B1 performs a converter operation and the Digital 14B2 and the communication part 15 perform the same action as FIG. 7(A).

In FIG. 7(C), the Digital (including digital compression calculation) 14C2 connected downstream of the ADC 14C1 included in the measurement part 12C executes compressed sampling to a digital signal. It is to be noted that the forms of observation matrix Φ to be achieved in the digital domain have variety, and, for example, a Gaussian random matrix, Bernoulli, or the like can be applied. The reconstruction processing unit 20, at a time of updating the dictionary matrix Ψ, creates the observation matrix Φ that increases the reconstruction accuracy, and sends to the Digital (including digital compression calculation) 14C2 as the sending information D1 so as to be updated and written. The observation matrix Φ is conveyed to the compression part on the side of the sensing unit 10, which enables suitable compression. It is to be noted that, in FIG. 7(C), an amplifier-filterer 13C performs preprocessing and the ADC 14C1 performs a converter operation.

Furthermore, a compression method of a hybrid model of FIG. 7(A) to FIG. 7(C) may be employed, and, in such a hybrid model, basically the same information as in each method is sent to the side of the sensing unit 10, an improvement of the reconstruction accuracy and narrowing (low power consumption) of circuit characteristics are able to be achieved.

As described above, a signal sending apparatus according to the present invention preferably includes a measurement part that compresses a target signal based on an observation matrix and captures a first signal, a first communication part that sends the first signal to outside, the first signal being captured into the measurement part, and a switching signal output part that outputs a switching signal, and the measurement part, when receiving the switching signal, preferably compresses the target signal at lower compression than the first signal and captures a second signal, and the first communication part preferably sends the captured second signal, to the outside.

According to the present invention, the target signal is compressed by the measurement part through the observation matrix, is captured as a first signal, and is sent to the outside by the first communication part. In addition, the measurement part is made to compress the target signal at lower compression than the first signal and captures a second signal, and, when receiving the switching signal from the switching signal output part, the second signal is sent to the outside by the first communication part. Accordingly, the measurement part and the first communication part perform the compression to the first signal and the external sending of the compressed signal as normal operations, which enables an operation with low power consumption. In addition, at a timing relevant to, for example, the update of the dictionary matrix for reconstruction, or the like, in a case in which an available second signal is captured, although power consumption is temporarily increased by low compression processing and sending processing, low-power operation is possible in other normal times, so that, while the operation is performed with low power consumption as a whole, the maintenance or the like of the reconstruction accuracy of the detection signal, for example, is able to be achieved. It is to be noted that lower compression than the first signal includes no compression.

In addition, the measurement part, when receiving the switching signal, preferably captures the second signal in place of the first signal. According to this configuration, when the second signal is captured, the first signal is not captured or sent, which thus results in an operation in low power consumption.

In addition, the measurement part preferably includes an analog circuit that performs preprocessing on the target signal, and the analog circuit, when capturing the first signal, is preferably supplied with first power and operates, and, when capturing the second signal, is preferably supplied with second power larger than the first power and operates. According to this configuration, when the second signal is captured, the second power is required, during the time, although consuming high power, the second signal is captured with low noise and high accuracy, and is suitable when applied on an external side, for example, to the update of the dictionary matrix or the like.

In addition, the measurement part preferably includes an analog circuit that performs preprocessing on the target signal, and the analog circuit, when capturing the first signal, is preferably set to a first passband, and, when capturing the second signal, is preferably set to a second passband larger than the first passband. According to this configuration, when the second signal is captured, since the larger second passband is set, during the time, although consuming high power, the second signal is detected as a signal including a frequency component in the second passband, which is suitable for an application example such as the update of the dictionary matrix with high correlation, for example.

In addition, the first communication part preferably outputs the switching instructions received from the outside, to the switching signal output part, and the switching signal output part, when receiving the switching instructions, preferably outputs the switching signal only for a predetermined time. According to this configuration, the switching instructions are enabled from the outside through the first communication part.

In addition, a setting part that outputs the switching instructions to the switching signal output part under a predetermined condition is preferably included, and the switching signal output part, when receiving the switching instructions, preferably outputs the switching signal only for a predetermined time. According to this configuration, the setting part enables the setting of the switching instructions at an appropriate timing, for example.

In addition, a signal reconstruction apparatus according to the present invention preferably includes a second communication part that receives signals from the first communication part of the signal sending apparatus, a dictionary memory that records a dictionary matrix, a reconstruction algorithm part that obtains an estimation signal by use of the observation matrix and the dictionary matrix, from the first signal among the signals received by the second communication part, and obtains a product of the obtained estimation signal and the dictionary matrix and derives a reconstruction signal, and a dictionary generation part that generates a new dictionary matrix, from the second signal among the signals received by the second communication part, and stores in the dictionary memory.

According to the present invention, the estimation signal is obtained from the first signal by use of the observation matrix and the dictionary matrix by the reconstruction algorithm part, and the product of the obtained estimation signal and the dictionary matrix is obtained to derive the reconstruction signal. On the other hand, a new dictionary matrix is generated from the second signal by the dictionary generation part and is stored in the dictionary memory. In this manner, the dictionary matrix is generated and updated from the second signal to maintain the high reconstruction accuracy for the reconstruction signal.

In addition, the present invention preferably includes a mode switching processing part that outputs the switching instructions, and the second communication part preferably sends the switching instructions to the outside. According to this configuration, the switching instructions are sent to the outside through the second communication part, for example, to the signal sending apparatus, and are applied to processing to capture the first and second signals.

In addition, the mode switching processing part preferably outputs the switching instructions in a case in which the reconstruction accuracy of the reconstruction signal is reduced. According to this configuration, the temporal variations, or the like of the target signal leads to a reduction in the reconstruction accuracy, and thus the switching instructions are outputted at an appropriate timing to update the dictionary matrix, which improves the correlation and maintains the reconstruction accuracy.

In addition, the mode switching processing part preferably outputs the switching instructions in a case in which a predetermined time elapses since previous dictionary generation. According to this configuration, the switching instructions are outputted periodically or for every predetermined period to update the dictionary matrix, which improves the correlation and maintains the reconstruction accuracy.

In addition, the mode switching processing part preferably receives an operation from the outside and preferably outputs the switching instructions. According to this configuration, the switching instructions are outputted at any timing by a manual operation, for example, from the outside, to update the dictionary matrix, which improves the correlation and maintains the reconstruction accuracy.

In addition, a signal transmission system according to the present invention preferably includes the signal sending apparatus and the signal reconstruction processing apparatus that are connected by the communication part, and this configuration enables low power consumption and is able to maintain the high reconstruction accuracy.

### Reference Signs List

1, 1A, 1B, 1C compressed sensing system
10 sensing unit (sensing apparatus)
11 sensor
12, 120, 12A, 12B, 12C measurement part
112, 121 first circuit
112', 122 second circuit
13, 13', 131, 132 analog circuit
14, 14', 141, 142 compression part
15 communication part (first communication part)
21 communication part (second communication part)
16 switching signal output part
20 reconstruction processing unit (reconstruction processing apparatus)
22 reconstruction algorithm part
23 dictionary memory
24 control part
241 dictionary generation part
242 mode switching processing part
SW21, SW11, SW12 switch

## Claims

1. A signal sending apparatus comprising:
a measurement part that compresses a target signal based on an observation matrix and captures a first signal;
a first communication part that sends the first signal to outside, the first signal being captured into the measurement part; and
a switching signal output part that outputs a switching signal, wherein:
the measurement part, when receiving the switching signal, compresses the target signal at lower compression than the first signal and captures a second signal; and
the first communication part sends the captured second signal, to the outside.

2. The signal sending apparatus according to claim 1, wherein the measurement part, when receiving the switching signal, captures the second signal in place of the first signal.

3. The signal sending apparatus according to claim 1, wherein:
the measurement part includes an analog circuit that performs preprocessing on the target signal; and
the analog circuit, when capturing the first signal, is supplied with first power and operates, and, when capturing the second signal, is supplied with second power larger than the first power and operates.

4. The signal sending apparatus according to claim 1, wherein:
the measurement part includes an analog circuit that performs preprocessing on the target signal; and
the analog circuit, when capturing the first signal, is set to a first passband, and, when capturing the second signal, is set to a second passband larger than the first passband.

5. The signal sending apparatus according to claim 1, wherein:
the first communication part outputs the switching instructions received from the outside, to the switching signal output part; and
the switching signal output part, when receiving the switching instructions, outputs the switching signal only for a predetermined time.

6. The signal sending apparatus according to claim 1, comprising a setting part that outputs switching instructions to the switching signal output part under a predetermined condition, wherein the switching signal output part, when receiving the switching instructions, outputs the switching signal only for a predetermined time.

7. A signal reconstruction processing apparatus comprising:
a second communication part that receives signals from the first communication part of the signal sending apparatus according to any one of claims 1 to 6;
a dictionary memory that records a dictionary matrix;
a reconstruction algorithm part that obtains an estimation signal by use of the observation matrix and the dictionary matrix, from the first signal among the signals received by the second communication part, and obtains a product of the obtained estimation signal and the dictionary matrix and derives a reconstruction signal; and
a dictionary generation part that generates a new dictionary matrix, from the second signal among the signals received by the second communication part, and stores in the dictionary memory.

8. The signal reconstruction processing apparatus according to claim 7, comprising a mode switching processing part that outputs switching instructions, wherein the second communication part sends the switching instructions to the outside.

9. The signal reconstruction processing apparatus according to claim 8, wherein the mode switching processing part outputs the switching instructions in a case in which reconstruction accuracy of the reconstruction signal is reduced.

10. The signal reconstruction processing apparatus according to claim 8, wherein the mode switching processing part outputs the switching instructions in a case in which a predetermined time elapses since previous dictionary generation.

11. The signal reconstruction processing apparatus according to claim 8, wherein the mode switching processing part receives an operation from the outside and outputs the switching instructions.

12. A signal transmission system comprising:
the signal sending apparatus according to any one of claims 1 to 6; and
the sound reconstruction processing apparatus according to claim 7.
